# EUROPÄISCHE PATENTANMELDUNG

(11) **EP 2 961 053 A1**
(43) Veröffentlichungstag der Anmeldung: **30.12.2015**
(21) Anmeldenummer: 14173946.6
(22) Anmeldetag: 25.06.2014
(51) Int. Cl.: H02M 3/28

(54) **Schaltnetzteil**

(71) Anmelder: Siemens Aktiengesellschaft, 80333 München (DE)
(72) Erfinder: Dyszewski, Janusz, 1200 Wien (AT); Reschenauer, Stefan, 2191 Atzelsdorf (AT); Schulz, Stefan, 2152 Gnadendorf (AT)
(74) Vertreter: Maier, Daniel Oliver

(57) **Zusammenfassung**

Die Erfindung betrifft ein Schaltnetzteil, welches zumindest zwei parallel geschaltete LLC-Resonanzwandler (1, 2) umfasst, wobei jeder LLC-Resonanzwandler (1, 2) eine Messschaltung (22, 23, 28, 29, 30, 31) umfasst, welche ein zum übertragenen Strom des zugeordneten LLC-Resonanzwandlers (1, 2) proportionales Messsignal erzeugt, wobei jedes Messsignal einer Lastregelung (25) zugeführt ist und wobei mittels der Lastregelung (25) zumindest eine Schaltfrequenz eines LLC-Resonanzwandlers (1, 2) in der Weise verändert wird, dass sich die Messsignale einander annähern. Damit wird eine exakte Strom- bzw. Leistungsaufteilung beim Parallelschalten mehrerer LLC-Resonanzwandler (1, 2) erreicht.

## Beschreibung

Die Erfindung betrifft ein Schaltnetzteil, welches zumindest zwei parallel geschaltete LLC-Resonanzwandler umfasst und ein Verfahren zur Regelung des Schaltnetzteils.

Die Bezeichnung LLC-Resonanzwandler rührt daher, dass zwei Induktivitäten und eine Kapazität einen Schwingkreis bilden. Konkret sind das die Magnetisierungsinduktivität und die dispergierende Induktivität (Streuinduktivität) eines Transformators sowie die Kapazität eines Resonanzkondensators. Durch den speziellen Aufbau des Transformators werden dabei gezielt parasitäre Effekte genutzt, die ansonsten unerwünscht sind. Manchmal erfolgt die Anordnung einer eigenen Resonanzspule, wenn die Streuinduktivität des Transformators nicht ausreicht. Beim LLC-Resonanzwandler ergeben sich damit ein hoher Wirkungsgrad und eine kleine Bauform.

Angesteuert wird der LLC-Resonanzwandler mit einer Schaltfrequenz, welche das Übersetzungsverhältnis und damit die Ausgangsspannung bestimmt. Eine Änderung der Schaltfrequenz führt somit zu einem geänderten Übersetzungsverhältnis. Damit lässt sich die Ausgangsspannung im Verhältnis zu einer Eingangsspannung festlegen. Ein solcher Wandler wird deshalb oft als frequenzabhängige Spannungsquelle interpretiert.

Wenn ein Schaltnetzteil mit einer hohen Ausgangsleistung gefordert ist, wird die Bauteilauslegung zunehmend schwierig. Insbesondere die Leistungsbauteile müssen dann für hohe Spannungen bzw. Ströme geeignet sein. Oftmals ist es günstiger, anstatt eines Wandlers mit speziellen Leistungsbauteilen mehrere LLC-Resonanzwandler mit Standardkomponenten parallel zu schalten. Dann teilt sich die zu übertragende Leistung auf die einzelnen Wandler auf. Diese Lösung bringt aber auch Probleme mit sich.

Bei eingangs- und ausgangsseitig parallel geschalteten LLC-Resonanzwandler teilt sich nämlich die Leistung nicht automatisch gleichmäßig auf, sondern entsprechend den jeweiligen Übersetzungsverhältnissen der einzelnen Wandler. Der LLC-Resonanzwandler mit dem höheren Übersetzungsverhältnis überträgt einen größeren Anteil der Ausgangsleistung. Dabei entspricht die resultierende Ausgangsspannung einem Mittelwert der einzelnen Wandler-Ausgangsspannungen.

Zu Berücksichtigen ist insbesondere das Frequenzverhalten des jeweiligen LLC-Resonanzwandlers, also die Abhängigkeit des Übersetzungsverhältnisses von der Schaltfrequenz. Diese Abhängigkeit ergibt sich aus den Eigenschaften der Resonanzbauteile. Bauteiltoleranzen bedingen somit Unterschiede zwischen parallel geschalteten Resonanzwandlern.

Werden LLC-Resonanzwandler parallel geschaltet und mit derselben Schaltfrequenz angesteuert, bestimmt die Streuung der Bauteiltoleranzen die Aufteilung der übertragenen Leistung. Mit einer engen Festlegung der Toleranzen ist es möglich, den maximalen Leistungsunterschied der Wandler zu begrenzen. Eine solche Maßnahme ist jedoch mit entsprechendem Aufwand verbunden, beispielsweise höheren Bauteilkosten.

Der Erfindung liegt die Aufgabe zugrunde, für ein Schaltnetzteil der eingangs genannten Art und ein Regelungsverfahren eine Verbesserung gegenüber dem Stand der Technik anzugeben.

Erfindungsgemäß wird diese Aufgabe gelöst durch ein Schaltnetzteil gemäß Anspruch 1 und ein Verfahren gemäß Anspruch 13. Weiterbildungen finden sich in abhängigen Ansprüchen.

Dabei umfasst jeder LLC-Resonanzwandler eine Messschaltung, welche ein zum übertragenen Strom des zugeordneten LLC-Resonanzwandlers proportionales Messsignal erzeugt, wobei jedes Messsignal einer Lastregelung zugeführt ist und wobei mittels der Lastregelung zumindest eine Schaltfrequenz eines LLC-Resonanzwandlers in der Weise verändert wird, dass sich die Messsignale einander annähern. Es wird also laufend der vom jeweiligen LLC-Resonanzwandler übertragene Stromanteil erfasst und durch Schaltfrequenzvariation dahingehend beeinflusst, dass sich die Stromanteile einander angleichen. Überträgt beispielsweise ein LLC-Resonanzwandler weniger Strom, wird die Ausgangsspannung dieses Wandlers im Verhältnis zu den anderen Wandlern erhöht. Dies geschieht durch Anpassung des Übersetzungsverhältnisses mittels Schaltfrequenzvariation. Konkret wird die Ausgangsspannung des LLC-Resonanzwandlers mit zu geringem Stromanteil angehoben, und/oder die Ausgangsspannungen der anderen Wandler werden herabgesetzt. Unter Berücksichtigung der jeweiligen Eingangs- bzw. Ausgangsspannung erfolgt durch die Angleichung der Stromanteile folglich eine Angleichung der übertragenen Leistungsanteile.

Ein wesentlicher Vorteil der Erfindung liegt darin, dass eine exakte Strom- bzw. Leistungsaufteilung beim Parallelschalten mehrerer LLC-Resonanzwandler erreicht wird. Das geschieht völlig unabhängig von den Bauteiltoleranzen der einzelnen Resonanzbauteile.

Jeder LLC-Resonanzwandler überträgt also einen exakt gleich großen Strom- bzw. Leistungsanteil, wodurch keine unnötigen Reserven bei der Bauteilauslegung vorzusehen sind. Für das Schaltnetzteil bedeutet dieser Vorteil die kleinstmögliche Baugröße.

Außerdem erreichen die einzelnen Bauteile der parallelgeschalteten LLC-Resonanzwandler infolge der gleichmäßigen Leistungsaufteilung dieselben Temperaturen, woraus eine angeglichene Lebensdauer aller Wandler resultiert.

In einer einfachen Ausprägung der Erfindung umfasst jeder LLC-Resonanzwandler eine Halbbrückenschaltung, welche jeweils an einer Eingangsspannung des Schaltnetzteils anliegt, wobei jede Halbbrückenschaltung mittels einer eigenen Ansteuerschaltung angesteuert ist. Jeder Wandler ist somit zunächst unabhängig angesteuert, wodurch baugleiche Einheiten gegen sind, die je nach Anwendungsfall in entsprechender Stückzahl parallelgeschaltet werden.

In weiterer Folge ist es von Vorteil, wenn jede Ansteuerschaltung zur Vorgabe einer Schaltfrequenzänderung mit der Lastregelung verbunden ist. Damit ist die Möglichkeit geschaffen, die Ausgangsspannung jedes LLC-Resonanzwandlers zu beeinflussen und eine bestmögliche Angleichung der Leistungsanteile sicherzustellen.

Eine Weiterbildung sieht vor, dass jeder LLC-Resonanzwandler einen Transformator mit einer Primärwicklung und zwei Sekundärwicklungen umfasst und dass jede Sekundärwicklung über einen Ausgangsgleichrichter mit einem eigenen Ausgangskondensator verbunden ist. Die Ausgangskondensatoren sind dabei parallel geschaltet.

In einer ersten Variante der Erfindung umfasst die jeweilige Messschaltung einen Temperatursensor, welcher neben einem Leistungsbauteil des zugeordneten LLC-Resonanzwandlers angeordnet ist, sodass das Messsignal proportional zu einer von diesem Leistungsbauteil abgegebenen Wärme ist. Damit wird der Effekt genutzt, dass ein Leistungsbauteil mit zunehmendem Stromfluss entsprechend mehr Wärme abgibt, weil mehr Verluste anfallen.

Hierbei ist es günstig, wenn der Temperatursensor neben einem Leistungsschalter oder neben einem Transformator oder neben einem Ausgangsgleichrichter des zugeordneten LLC-Resonanzwandlers angeordnet ist. Die Verluste dieser Bauteile steigen mit zunehmendem Strom, wodurch die entsprechende Wärmeabgabe zu einem ausreichend genauen Messsignal führt.

Eine zweite Variante sieht vor, dass die jeweilige Messschaltung zur Rippelspannungserfassung parallel zu einem Resonanzkondensator des zugeordneten LLC-Resonanzwandlers angeordnet ist und dass der Lastregelung als jeweiliges Messsignal eine Rippelspannung zugeführt ist. Die Rippelspannung ist dabei direkt proportional zum Spitzenwert des Primärstromes. Eine unterschiedliche Leistungsaufteilung führt somit zu einer unterschiedlichen Rippelspannungen an den Resonanzkondensatoren der parallel geschalteten Wandler.

Dabei ist es günstig, wenn die Messschaltung einen Spannungswandler oder eine Ladungspumpe oder einen Mikrocontroller zur Rippelspannungserfassung umfasst. Bei Verwendung eins Mikrocontrollers wandelt ein Analog-DigitalUmsetzer die analoge Rippelspannung in ein digitales Signal um. Eine weitere Verarbeitung mittels eines im Mikrocontroller eingerichteten Regelungsalgorithmus ist dann ohne weitere Zwischenschritte möglich.

In einer dritten Variante ist vorgesehen, dass die jeweilige Messschaltung ein Strommesselement zum Messen eines Stromes in der zugeordneten Halbbrückenschaltung umfasst und dass der Lastregelung als jeweiliges Messsignal eine zum gemessenen Strom proportionale Spannung zugeführt ist. Aus dem gemessenen Strom folgt unter Berücksichtigung der Eingangs- bzw. Ausgangsspannung die momentan übertragene Leistung.

Einfacherweise ist das Strommesselement ein Shunt-Widerstand, an dem der Spannungsabfall als Messgröße erfasst wird. Alternativ dazu kann es sinnvoll sein, dass die jeweilige Messschaltung ein Strommesselement zum Messen eines Eingangsstromes des zugeordneten Transformators umfasst und dass der Lastregelung als jeweiliges Messsignal eine zum gemessenen Strom proportionale Spannung zugeführt ist. Auch aus diesem Strommesswert folgt unter Berücksichtigung der Eingangs- bzw. Ausgangsspannung die übertragene Leistung.

Als Strommesselement kommt hier günstigerweise ein Stromwandler zum Einsatz, weil es sich um einen gemessenen Wechselstrom handelt.

Bei einem erfindungsgemäßen Verfahren zur Regelung des beschriebenen Schaltnetzteils wird für jeden LLC-Resonanzwandler ein Messsignal erfasst, welches proportional zum übertragenen Strom des jeweiligen LLC-Resonanzwandlers ist, wobei aus den Messsignalen eine Regelabweichung gebildet wird und wobei daraus eine Änderungsgröße für zumindest eine Schaltfrequenz eines LLC-Resonanzwandler vorgegeben wird, um die Messsignale einander anzunähern.

In einer einfachen Ausführung des Verfahrens wird lediglich die Schaltfrequenz eines LLC-Resonanzwandlers mittels Lastregelung geregelt.

Bessere Ergebnisse erhält man, wenn bei zwei parallel geschalteten LLC-Resonanzwandlern die Schaltfrequenzen beider LLC-Resonanzwandler invers zueinander verändert werden. Auf diese Weise ist bei auftretenden Leistungsunterschieden eine rasche Ausregelung sichergestellt.

Die Erfindung wird nachfolgend in beispielhafter Weise unter Bezugnahme auf die beigefügten Figuren erläutert. Es zeigen in schematischer Darstellung:
- Fig. 1: Parallelschaltung zweier LLC-Resonanzwandler mit Temperatursensoren
- Fig. 2: Parallelschaltung zweier LLC-Resonanzwandler mit Rippelspannungserfassung
- Fig. 3: Parallelschaltung zweier LLC-Resonanzwandler mit Strommessung in der jeweiligen Halbbrückenschaltung
- Fig. 4: Parallelschaltung zweier LLC-Resonanzwandler mit Strommessung am Eingang des jeweiligen Transformators

Die Parallelschaltung der beiden LLC-Resonanzwandler 1, 2 liegt an einer gemeinsamen Eingangsspannung 3 an. Spannungsquelle 4 ist beispielsweise eine gleichgerichtete Netzspannung. Die jeweilige Halbbrückenschaltung besteht aus zwei Schaltelementen 5, 6 und zwei Resonanzkondensatoren 7, 8 und ist eingangsseitig an die Eingangsspannung 3 angeschlossen. Die Eingangsspannung 3 ist dabei auf ein Massepotenzial 9 bezogen. Am Ausgang der Halbbrückenschaltung ist eine Primärwicklung 10 eines Transformators 11 in Serie mit einer Resonanzinduktivität 12 angeordnet. Bei der Resonanzinduktivität 12 kann es sich um eine eigene Spule oder um eine Streuinduktivität des Transformators 11 handeln.

Angesteuert werden die beiden Schaltelemente 5, 6 mittels einer Ansteuerschaltung 13. Diese erzeugt Steuerimpulse, welche beispielsweise mittels eines Ansteuerübertragers galvanisch getrennt auf den Leistungsteil des Resonanzwandlers 5, 6 übertragen werden. Angeschlossen ist die Ansteuerschaltung 13 an eine Versorgungsspannung 14 und an das Massepotenzial 9.

Sekundärseitig sind zwei Sekundärwicklungen 15, 16 angeordnet, die über einen jeweiligen Ausgangsgleichrichter 17, 18 mit einem Ausgangskondensator 19 verbunden sind.

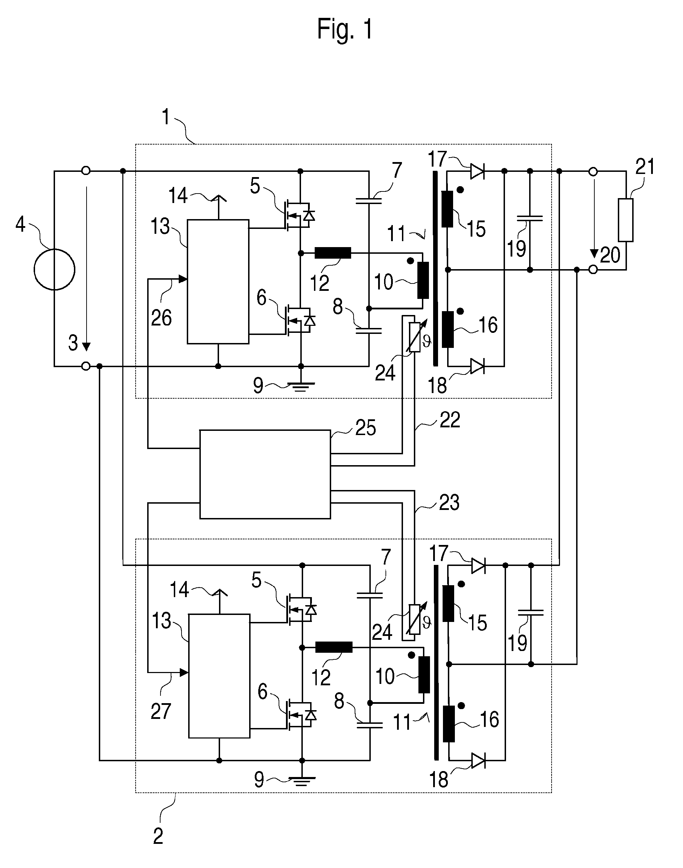

Der zweite LLC-Resonanzwandler 2 ist entsprechend aufgebaut, wobei die Ausgangskondensatoren 19 der beiden Wandler 1, 2 parallel geschaltet sind. An Ihnen liegt eine Ausgangsspannung 20 an, mit der eine Last 21 versorgt wird. In der in Fig. 1 dargestellten Variante der Erfindung umfasst jeder Resonanzwandler 1, 2 eine Messschaltung 22, 23 mit einem Temperatursensor 24, welcher räumlich in unmittelbarer Nähe eines Leistungs-Bauelements angeordnet ist. Das können die Schaltelemente 5, 6 der Halbbrückenschaltung, der Transformator 11 oder der Ausgangsgleichrichter 17, 18 sein.

Die mittels der Temperatursensoren 24 erfassten Messwerte (z.B. Temperaturwerte in Grad Celsius) sind einer gemeinsamen Lastregelung 25 als Messsignale zugeführt. Sobald zwischen den Messsignalen eine Differenz auftritt, gibt die Lastregelung 25 an jede Ansteuerschaltung 13 ein jeweiliges Stellsignal 26, 27 aus, mittels dem die jeweilige Schaltfrequenz in der Weise geändert wird, dass sich die Messsignale wieder annähern. Die beiden Resonanzwandler 1, 2 arbeiten dann mit unterschiedlichen Schaltfrequenzen. Die jeweilige Ausgangsspannung eines Resonanzwandlers 1, 2 ist dabei von der entsprechenden Schaltfrequenz abhängig, wobei die resultierende Ausgangsspannung dem Mittelwert der einzelnen Wandler-Ausgangsspannungen entspricht.

Die Schaltfrequenzänderung erfolgt zum Beispiel in der Weise, dass zunächst beiden Resonanzwandlern 1, 2 eine gemeinsame Schaltfrequenz vorgegeben wird, welche der gewünschten Ausgangsspannung 20 entspricht. Die Lastregelung 25 gibt dann jeder Ansteuerschaltung 13 als jeweilige Stellgröße 26, 27 einen Korrekturwert vor, mit dem die gemeinsame Schaltfrequenz für jeden Resonanzwandler 1, 2 separat abgeändert wird.

Alternativ dazu ist die Lastregelung 25 so eingerichtet, dass Sie jeder Ansteuerschaltung 13 als Stellgröße 26, 27 eine bereits abgeänderte Schaltfrequenz vorgibt.

In einer einfacheren Ausprägung kann es ausreichend sein, wenn nur einer Ansteuerschaltung 13 ein Korrekturwert bzw. eine abgeänderte Schaltfrequenz vorgegeben wird, um die beiden erfassten Messsignale einander anzunähern.

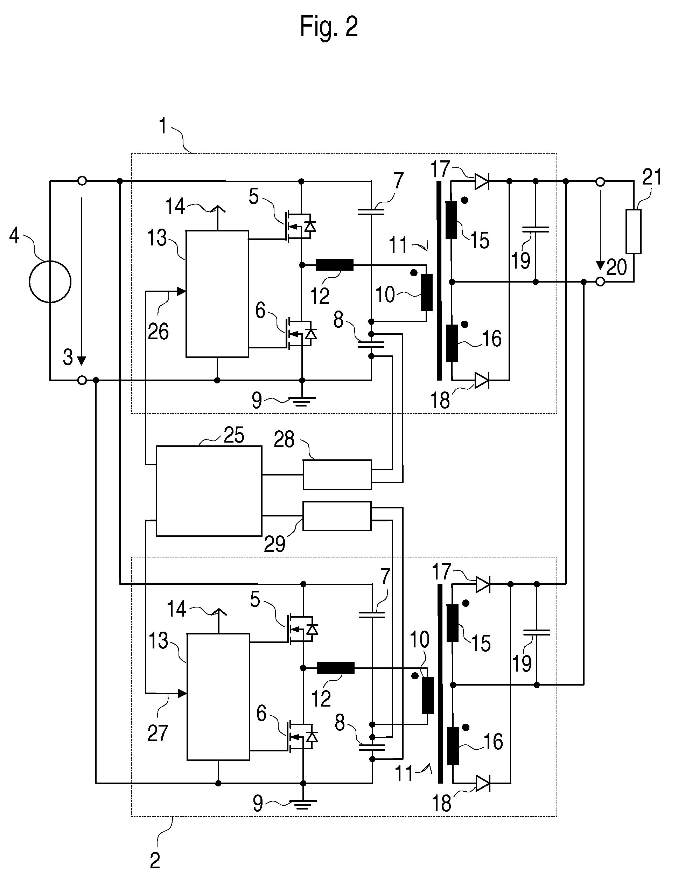

Bis auf die Messsignalerfassung entspricht der jeweils in den Figuren 2 bis 4 dargestellte Aufbau jenem in Fig. 1.

In der Ausführung gemäß Fig. 2 wird anstatt der Temperatur eine Rippelspannung erfasst. Dazu wird am jeweiligen Resonanzwandler 1, 2 laufend die Spannung an einem Resonanzkondensator 8 abgegriffen und ausgewertet. Für jeden Resonanzwandler 1, 2 ist dazu eine Messschaltung 28, 29 zur Rippelspannungserfassung angeordnet, die ein entsprechendes Messsignal an die gemeinsame Lastregelung 25 liefert.

Bei Leistungsunterschieden zwischen den beiden Resonanzwandlern 1, 2 arbeitet die Lastregelung 25 wie oben beschrieben, um die Messsignale einander anzunähern.

Die jeweilige Messschaltung 28, 29 umfasst zur Erfassung der Rippelspannung entweder einen Spannungswandler oder eine Ladungspumpe. Eine weitere Variante sieht einen Mikrocontroller vor, der die Rippelspannung in digitaler Form erfasst. Dabei wird der Mikrocontroller günstigerweise auch zur Implementierung der Lastregelung 25 genutzt.

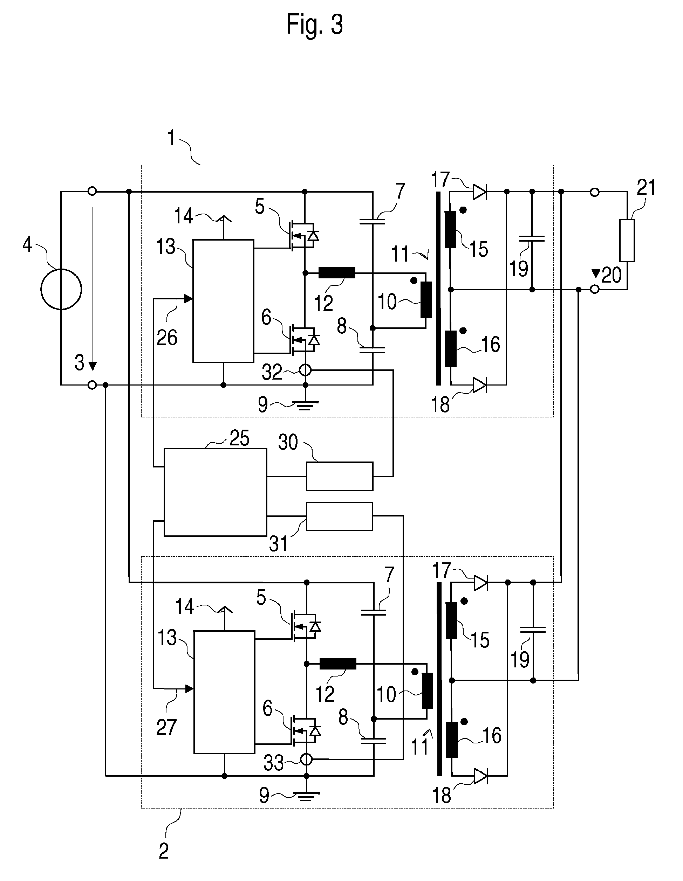

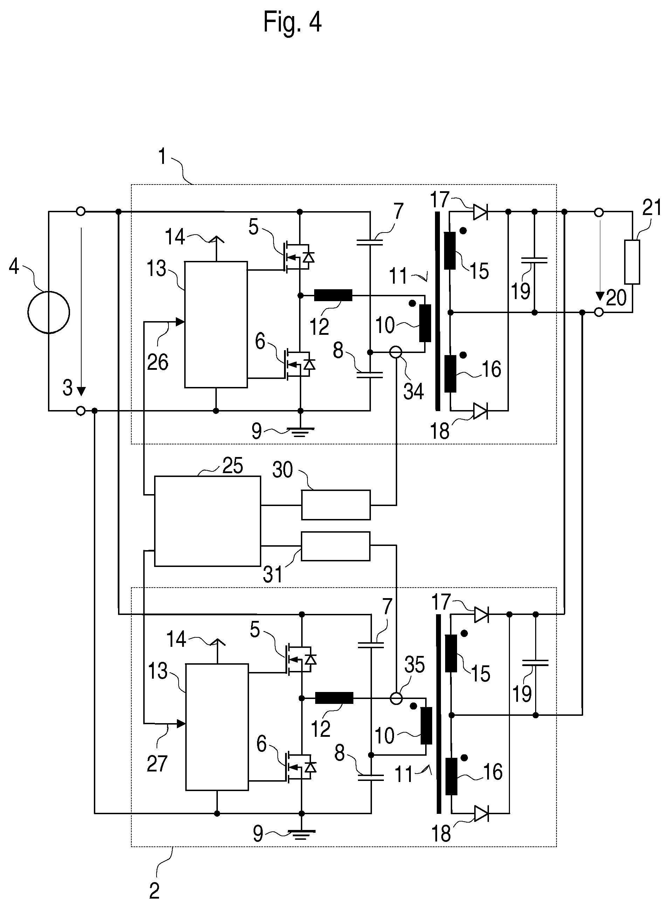

Die in den Figuren 3 und 4 dargestellten Varianten umfassen für jeden Resonanzwandler 1,2 eine Messschaltung 30, 31, mit einem Strommesselement 32, 33, 34, 35. Der Lastregelung 25 ist als jeweiliger Messwert eine Spannung zugeführt, die proportional zum gemessenen Strom ist.

In der Ausführung gemäß Fig. 3 ist das jeweilige Strommesselement 32, 33 direkt in der Halbbrückenschaltung angeordnet. Einfacherweise ist ein Shunt-Widerstand vorgesehen, an dem eine messbare Spannung abfällt.

Die Ausführung gemäß Fig. 4 sieht eine Messung des durch die Primärwicklung des Transformators 11 fließenden Stromes vor. Da es sich hierbei um einen Wechselstrom handelt, ist beispielsweise ein Stromwandler einsetzbar.

Das jeweils erfasste Strommessignal wird wiederum der gemeinsamen Lastregelung 25 zugeführt, wobei deren Funktionsweise der oben beschriebenen entspricht.

## Patentansprüche

1. Schaltnetzteil, welches zumindest zwei parallel geschaltete LLC-Resonanzwandler (1, 2) umfasst, **dadurch gekennzeichnet, dass** jeder LLC-Resonanzwandler (1, 2) eine Messschaltung (22, 23, 28, 29, 30, 31) umfasst, welche ein zum übertragenen Strom des zugeordneten LLC-Resonanzwandlers (1, 2) proportionales Messsignal erzeugt, dass jedes Messsignal einer Lastregelung (25) zugeführt ist und dass mittels der Lastregelung (25) zumindest eine Schaltfrequenz eines LLC-Resonanzwandlers (1, 2) in der Weise verändert wird, dass sich die Messsignale einander annähern.

2. Schaltnetzteil nach Anspruch 1, **dadurch gekennzeichnet, dass** jeder LLC-Resonanzwandler (1, 2) eine Halbbrückenschaltung umfasst, welche jeweils an einer Eingangsspannung (3) des Schaltnetzteils anliegt und dass jede Halbbrückenschaltung mittels einer eigenen Ansteuerschaltung (13) angesteuert ist.

3. Schaltnetzteil nach Anspruch 2, **dadurch gekennzeichnet, dass** jede Ansteuerschaltung (13) zur Vorgabe einer Schaltfrequenzänderung mit der Lastregelung (25) verbunden ist.

4. Schaltnetzteil nach einem der Ansprüche 1 bis 3, **dadurch gekennzeichnet, dass** jeder LLC-Resonanzwandler (1, 2) einen Transformator (11) mit einer Primärwicklung (10) und zwei Sekundärwicklungen (15, 16) umfasst und dass jede Sekundärwicklung (15, 16) über einen Ausgangsgleichrichter (17, 18) mit einem eigenen Ausgangskondensator (19) verbunden ist.

5. Schaltnetzteil nach einem der Ansprüche 1 bis 4, **dadurch gekennzeichnet, dass** die jeweilige Messschaltung (22, 23) einen Temperatursensor (24) umfasst, welcher neben einem Leistungsbauteil des zugeordneten LLC-Resonanzwandlers (1, 2) angeordnet ist, sodass das Messsignal proportional zu einer von diesem Leistungsbauteil abgegebenen Wärme ist.

6. Schaltnetzteil nach Anspruch 5, **dadurch gekennzeichnet, dass** der Temperatursensor (24) neben einem Leistungsschalter (5, 6) oder neben einem Transformator (11) oder neben einem Ausgangsgleichrichter (17, 18) des zugeordneten LLC-Resonanzwandlers (1, 2) angeordnet ist.

7. Schaltnetzteil nach einem der Ansprüche 1 bis 4, **dadurch gekennzeichnet, dass** die jeweilige Messschaltung (28, 29) zur Rippelspannungserfassung parallel zu einem Resonanzkondensator (8) des zugeordneten LLC-Resonanzwandlers (1, 2) angeordnet ist und dass der Lastregelung (25) als jeweiliges Messsignal eine Rippelspannung zugeführt ist.

8. Schaltnetzteil nach Anspruch 7, **dadurch gekennzeichnet, dass** die Messschaltung (28, 29) einen Spannungswandler oder eine Ladungspumpe oder einen Mikrocontroller zur Rippelspannungserfassung umfasst.

9. Schaltnetzteil nach einem der Ansprüche 2 bis 4, **dadurch gekennzeichnet, dass** die jeweilige Messschaltung (30, 31) ein Strommesselement (32, 33) zum Messen eines Stromes in der zugeordneten Halbbrückenschaltung umfasst und dass der Lastregelung (25) als jeweiliges Messsignal eine zum gemessenen Strom proportionale Spannung zugeführt ist.

10. Schaltnetzteil nach Anspruch 9, **dadurch gekennzeichnet, dass** das Strommesselement (32, 33) ein Shunt-Widerstand ist.

11. Schaltnetzteil nach Anspruch 4, **dadurch gekennzeichnet, dass** die jeweilige Messschaltung ein Strommesselement (34, 35) zum Messen eines Eingangsstromes des zugeordneten Transformators (11) umfasst und dass der Lastregelung (25) als jeweiliges Messsignal eine zum gemessenen Strom proportionale Spannung zugeführt ist.

12. Schaltnetzteil nach Anspruch 11, **dadurch gekennzeichnet, dass** das Strommesselement (34, 35) ein Stromwandler ist.

13. Verfahren zur Regelung eines Schaltnetzteils nach einem der Ansprüche 1 bis 12, **dadurch gekennzeichnet, dass** für jeden LLC-Resonanzwandler (1, 2) ein Messsignal erfasst wird, welches proportional zum übertragenen Strom des jeweiligen LLC-Resonanzwandlers (1, 2) ist, dass aus den Messsignalen eine Regelabweichung gebildet wird und dass daraus eine Änderungsgröße für zumindest eine Schaltfrequenz eines LLC-Resonanzwandler (1, 2) vorgegeben wird, um die Messsignale einander anzunähern.

14. Verfahren nach Anspruch 13, **dadurch gekennzeichnet, dass** lediglich die Schaltfrequenz eines LLC-Resonanzwandlers (1, 2) mittels Lastregelung (25) geregelt wird.

15. Verfahren nach Anspruch 13, **dadurch gekennzeichnet, dass** bei zwei parallel geschalteten LLC-Resonanzwandlern (1, 2) die Schaltfrequenzen beider LLC-Resonanzwandler (1, 2) invers zueinander verändert werden.
